# EUROPÄISCHE PATENTSCHRIFT

(11) **EP 3 227 693 B1**
(45) Veröffentlichungstag und Bekanntmachung des Hinweises auf die Patenterteilung: **04.10.2023**
(21) Anmeldenummer: 15700582.8
(22) Anmeldetag: 16.01.2015
(51) Int. Cl.: G01R 15/24

(54) **OPTOELEKTRISCHE MESSVORRICHTUNG ZUM MESSEN EINES ELEKTRISCHEN STROMES**
OPTOELECTRIC MEASURING DEVICE FOR MEASURING AN ELECTRICAL CURRENT
DISPOSITIF DE MESURE OPTOÉLECTRIQUE DE MESURE D'UN COURANT ELECTRIQUE

(43) Veröffentlichungstag der Anmeldung: 11.10.2017
(73) Patentinhaber: Siemens Energy Global GmbH & Co. KG, 81739 München (DE)
(72) Erfinder: HOFSTETTER, Michael, 81371 München (DE); ERGIN, Dominik, 91083 Baiersdorf (DE); WILLSCH, Michael, 07745 Jena (DE)
(86) Internationale Anmeldenummer: PCT/EP2015/050774
(87) Internationale Veröffentlichungsnummer: WO 2016/112993

(56) Entgegenhaltungen:
- DE-A1- 19 608 944
- US-A- 3 513 322
- US-A- 3 597 683
- US-A1- 2012 286 767

## Beschreibung

Die Erfindung betrifft eine Messvorrichtung zum Messen eines elektrischen Stromes mit einer Lichtquelle zum Erzeugen eines polarisierten Primärlichtsignals zum Einspeisen in eine Faraday-Sensoreinrichtung sowie mit einem Detektor zum Erfassen eines von der Faraday-Sensoreinrichtung bereitgestellten, gegenüber dem Primärlichtsignal polarisationsveränderten Sekundärlichtsignals.

Eine Messvorrichtung dieser Art ist beispielsweise aus der EP 0 865 610 B1 bekannt. Die Messung des elektrischen Stromes beruht dabei auf dem sogenannten Faraday-Effekt. Unter dem Faraday-Effekt wird die Veränderung des Brechungsindex bestimmter Materialien in Abhängigkeit von einem Magnetfeld verstanden. Dieser Effekt kann zur Veränderung eines Polarisierungszustandes von Licht, welches das Material durchläuft, genutzt werden. Speziell bei einem linear polarisierten Licht wirkt sich die Veränderung als eine Drehung einer Polarisationsebene des Lichtes aus. Der entsprechende Drehwinkel der Drehung ist idealerweise proportional zu einem Wegintegral über das Magnetfeld entlang des vom Licht zurückgelegten Weges im Material. Aus der Erfassung der Veränderung des Polarisationszustandes in einem Detektor und deren anschließender Auswertung kann demnach eine Meßgröße gewonnen werden, die eine Information über einen das Magnetfeld erzeugenden Strom enthält.

Nachteilig bei der bekannten Messvorrichtung ist der Umstand, dass die Genauigkeit der Messung des Polarisationszustandes, beispielsweise eines Polarisationswinkels, die üblicherweise mittels Interferometern oder Polarisationsanalysatoren erfolgt, relativ aufwendig und nur von begrenzter Genauigkeit ist. So ist dieser Effekt nur bis zu einer Polarisationsdrehung von 90° eindeutig, und Nichtlinearität sowie Temperaturabhängigkeit dieses Faraday-Effekts begrenzen beispielsweise die Genauigkeit. Eine Erhöhung der Genauigkeit ist stets mit einer Steigerung der Kosten des Detektors und einer erhöhten Fehleranfälligkeit der Messvorrichtung verbunden.

Aus der US 3 513 322 A ist ein Verfahren zum Messen eines elektrischen Stromes bekannt, bei dem der Faraday-Effekt verwendet wird, wobei mittels eines Sekundärstromes die Polarisationsänderung eines Mess-Lichtsignals kompensiert wird.

Messverfahren unter Ausnutzung des Faraday-Effektes sind des Weiteren aus der US 3 597 683 A, der DE 196 08 944 A1 und der US 2012/0286767 A1 bekannt.

Die Aufgabe der Erfindung besteht darin, eine Messvorrichtung der oben genannten Art vorzuschlagen, die eine möglichst genaue und zuverlässige Messung erlaubt.

Die Aufgabe wird durch eine Messvorrichtung gemäß dem Patentanspruch 1 gelöst. Dabei ist ein Kompensationselement bereitgestellt, mittels dessen die Polarisationsänderung des Sekundärlichtsignals durch eine entgegengesetzte Polarisationsänderung kompensierbar und ein von der entgegengesetzten Polarisationsänderung abhängiges Meßsignal für den elektrischen Strom ableitbar ist.

Die Erfindung beruht auf der Erkenntnis, dass eine Nullmessung gegenüber der direkten Messung des Polarisationszustandes genauer, mit reduzierter Abhängigkeit von Umgebungseinflüssen und mit vermindertem Aufwand des Detektionsschemas durchgeführt werden kann. Aufgrund der Kompensation der Polarisationsänderung des Sekundärlichtsignals braucht der Detektor in diesem Fall lediglich auf eine Nullmessung der Polarisationsänderung abgestimmt zu sein. Mit anderen Worten ist grundsätzlich eine Messung im Detektor notwendig, die lediglich feststellt, ob eine Polarisationsänderung vorliegt oder nicht. Die Kompensation der Polarisationsänderung wird dabei durch die entgegengesetzte Polarisationsänderung erreicht, also durch eine erneute Polarisationsänderung, die der in der Faraday-Sensoreinrichtung erzielten Polarisationsänderung entgegenwirkt. Beispielsweise könnte eine Drehung der Polarisationsebene eines linear polarisierten Primärlichtsignals um einen bestimmten Drehwinkel durch eine erneute Drehung der Polarisationsebene des Sekundärlichtsignals um einen Drehwinkel gleichen Betrages jedoch entgegengesetzter Richtung kompensiert werden.

Das Messsignal für den zu messenden elektrischen Strom wird dabei in Abhängigkeit von der entgegengesetzten Polarisationsänderung abgeleitet. Dies bedeutet, dass zur Ableitung des Messsignals bei der erfindungsgemäßen Messvorrichtung nicht unmittelbar die Polarisationsänderung, sondern ein Maß für die entgegengesetzte Polarisierung herangezogen wird.

Auf diese Weise vereint die erfindungsgemäße Messvorrichtung die Vorteile der bekannten Faraday-Effekt basierten Messvorrichtungen mit den Vorteilen einer Nullmessung.

Ein weiterer Vorteil der erfindungsgemäßen Messvorrichtung ergibt sich daraus, dass durch die Möglichkeit einer Verwendung von Lichtwellenleitern zwischen der Faraday-Sensoreinrichtung und dem Detektor im Falle einer Anwendung in der Hochspannungstechnik eine Spannungsisolation kostengünstig realisiert werden kann, weil diese ohnehin systemimmanent sind. Das Kompensationselement kann durch die Möglichkeit der Positionierung auf Erdpotenzial elektrisch angesteuert werden. Zugleich kann der Detektor in dessen idealem Arbeitspunkt arbeiten. Dadurch kann eine hohe Messgenauigkeit erreicht werden. Zudem ist eine Messung möglich, die von unerwünschten Nebeneffekten, beispielsweise Temperatureffekten, unabhängig ist. Ein Vorteil der vorliegenden Erfindung ist somit eine verbesserte Zuverlässigkeit der Messung.

Die vorliegende Erfindung eignet sich sowohl zur Messung von Gleichströmen als auch zur Messung von Wechselströmen.

Die Faraday-Sensoreinrichtung zum Führen des Primärlichtsignals kann beispielsweise eine Lichtfaser-Spule oder einen Glasring umfassen. Geeigneterweise ist die Lichtfaserspule bzw. der Glasring um einen Stromleiter oder ein Stromkabel gewickelt, das den zu messenden elektrischen Strom führt. Durch einen Mehrfachdurchgang des Lichts durch das vom fließenden Strom erzeugte Magnetfeld kann die Polarisationsänderung verstärkt werden. Bei dem Glas des Glasringes handelt es sich beispielsweise um Bulkglas.

Das Kompensationselement kann beispielsweise ein optoelektrisches Kompensationselement sein, das optische und elektrischen Strom leitende Elemente umfasst.

Gemäß einer bevorzugten Ausführungsform der Erfindung umfasst das Kompensationselement eine kompensierende Faraday-Sensoreinrichtung sowie einen ortsnah an der kompensierenden Faraday-Sensoreinrichtung angeordneten Kompensations-Stromleiter, wobei das Sekundärlichtsignal die kompensierende Faraday-Sensoreinrichtung durchläuft und ein Kompensationsstrom im Kompensations-Stromleiter derart einstellbar ist, dass die Polarisationsänderung des Sekundärlichtsignals kompensierbar ist, wobei das Messsignal vom Kompensationsstrom ableitbar ist. Der Kompensations-Stromleiter führt demnach einen Strom, der ein kompensierendes Magnetfeld erzeugt. Das kompensierende Magnetfeld wirkt auf das Sekundärlichtsignal, weil sich die das Sekundärlichtsignal führende kompensierende Faraday-Sensoreinrichtung in dessen örtlicher Nähe befindet. Das kompensierende Magnetfeld bewirkt geeigneterweise die entgegengesetzte Polarisierungsänderung, durch die die Polarisationsänderung des Sekundärlichtsignals kompensiert wird. Der Kompensationsstrom durch den Kompensations-Stromleiter kann derart eingestellt werden, dass die Kompensierung der Polarisationsänderung bewirkt ist. Somit trägt der Wert des Kompensationsstromes eine quantitative Information über den zu messenden elektrischen Strom. Daher kann das Meßsignal aus dem Kompensationsstrom abgeleitet werden. Diese Ausführungsform der Erfindung weist den Vorteil auf, dass das Meßsignal relativ einfach aus dem Kompensationsstrom gewonnen werden kann. Der Detektor ist hierbei geeigneterweise dazu eigerichtet, festzustellen, ob die (vollständige) Kompensation der Polarisationsänderung bei einem gegebenen Strom durch den Kompensations-Stromleiter vorliegt oder nicht. Dies erlaubt einen besonders einfachen und robusten Aufbau des Detektors. Zudem spielen eventuelle Nichtlinearitäten des Detektors keine Rolle.

Bevorzugt umfasst das Kompensationselement eine Regelungseinrichtung, die zu einer Nullregelung der Polarisationsänderung des Sekundärlichtsignals oder einer davon abgeleiteten Regelgröße mit Hilfe des Kompensationsstromes als Stellgröße eingerichtet ist. Demnach ist die Regelungseinrichtung dazu eingerichtet, den Kompensationsstrom durch den Kompensations-Stromleiter zu verändern, bis die Polarisationsänderung durch eine entgegengesetzte Polarisierung in der kompensierenden Faraday-Sensoreinrichtung kompensiert wird. Nullregelung soll in diesem Zusammenhang also bedeuten, dass die Regelgröße auf einen Sollwert gleich null geregelt werden soll. Die Regelgröße ist dabei durch die Polarisationsänderung oder die davon abgeleitete Größe gegeben. Die Rückkopplung im Regelkreis erfolgt dabei geeigneterweise über die mittels des Detektors gewonnene Information über den Polarisationszustand des Sekundärlichtsignals. Das Meßsignal für den zu messenden elektrischen Strom kann dann aus dem Wert des Kompensationsstromes gewonnen werden. Der zur vollständigen Kompensation der Polarisationsänderung notwendige Kompensationsstrom trägt nämlich eine Information über den zu messenden elektrischen Strom. Zur Ermittlung des Meßsignals kann beispielsweise eine über einen geeigneten, vom Kompensationsstrom durchflossenen Messwiderstand gemessene Spannung verwendet werden. Die Nullregelung erlaubt eine besonders genaue Messung des elektrischen Stromes. Zudem kann die Regelung aktiv oder passiv ausgeführt sein (durch Verwendung aktiver bzw. passiver Elemente im Regelkreis) und kann hochdynamisch erfolgen. Dies führt vorteilhaft zu einer möglichen kurzen Totzeit von wenigen Mikrosekunden. Die Schnelligkeit der Messung ist physikalisch durch die Länge der lichtführenden Teile der Messvorrichtung sowie durch die Geschwindigkeit des Detektors definiert.

Bevorzugt sind die Faraday-Sensoreinrichtung und die kompensierende Faraday-Sensoreinrichtung gleichartig aufgebaut. Ist die kompensierende Faraday-Sensoreinrichtung eine Lichtfaser-Spule, so können die Wicklungen der Lichtfaser-Spule beispielsweise um den Kompensations-Stromleiter gewickelt sein. Die Anzahl der Wicklungen der Faraday-Sensoreinrichtung und der kompensierenden Faraday-Sensoreinrichtung ist dazu geeignet, ein Übersetzungsverhältnis zwischen dem zu messenden elektrischen Strom und dem zur Kompensation der Polarisationsänderung notwendigen Kompensationsstrom zu definieren. Durch die Mehrfachverwendung gleichartiger Teile können die Kosten der Messvorrichtung vorteilhaft gesenkt werden. Ferner können auf diese Weise etwaige Temperatureffekte gemindert werden, falls in der Umgebung der beiden Sensoreinrichtungen gleiche Temperatur gewährleistet oder die Temperaturabhängigkeit der maßgeblichen Effekte bekannt ist, so dass eventuelle Temperaturunterschiede kalibrierbar bzw. herausrechenbar sind.

Bevorzugt ist der Detektor zum Erfassen einer Lichtintensität in Abhängigkeit von einem Polarisationszustand des Sekundärlichtsignals eingerichtet. Der Polarisationszustand ist dabei beispielsweise ein Polarisationswinkel gegenüber einem voreingestellten Nullwinkel des Detektors. Zum Erfassen der Lichtintensität kann der Detektor zum Beispiel eine Fotodiode umfassen. Geeigneterweise ist der Detektor also dazu eingerichtet, den Polarisationszustand des Sekundärlichtsignals quantitativ auszuwerten. Zur quantitativen Auswertung kann die Messvorrichtung bzw. der Detektor geeignete Verrechnungsbauteile aufweisen.

Gemäß einer vorteilhaften Ausführungsform der Erfindung umfasst der Detektor einen Polarisationsanalysator. Der Polarisationsanalysator kann beispielsweise derart ausgebildet sein, dass er beim Durchgang eines linearpolarisierten Licht signals durch den Polarisationsanalysator ein Intensitätssignal liefert, das von dem Polarisationswinkel des Lichtsignals abhängig ist. Das Intensitätssignal kann dann beispielsweise von der Fotodiode aufgenommen und an eine geeignete Recheneinheit weitergeleitet werden. Diese Möglichkeit zur Erfassung der Intensität in Abhängigkeit vom Polarisationszustand ist besonders einfach und daher entsprechend günstig und zuverlässig.

Bevorzugt ist der Polarisationsanalysator derart eingestellt, dass ein Sekundärlichtsignal ohne Polarisationsänderung ein Nullsignal an einem Ausgang des Detektors ergibt. Dies kann durch eine geeignete Wahl eines Nullwinkels erfolgen. Nullsignal soll in diesem Zusammenhang bedeuten, dass das Polarisationsanalysator gelieferte Intensitätssignal im Rahmen der Messgenauigkeit null beträgt, wenn das Sekundärlichtsignal gegenüber dem Primärlichtsignal keine Polarisationsänderung aufweist. Dies ist beispielsweise auch dann der Fall, wenn die Polarisationsänderung des Sekundärlichtsignals mittels des Kompensationselementes vollständig kompensiert worden ist.

Es ist hierbei anzumerken, dass der Detektor auch auf anderen Messprinzipien basieren kann. Beispielsweise kann der Detektor ein Sagnak-Interferometer zum Erfassen der Intensität in Abhängigkeit vom Polarisationszustand umfassen. Darüber hinaus kann jede geeignete interferometrische Auswertung verwendet werden.

Gemäß einer besonders bevorzugten Ausführungsform der Erfindung ist die Faraday-Sensoreinrichtung in der Nähe eines Mittel- oder Hochspannungs-Stromleiters angeordnet, so dass das Meßsignal für den elektrischen Strom in dem Hochspannungs-Stromleiter ableitbar ist. Mit anderen Worten ist die Messvorrichtung insbesondere dazu geeignet, Strom auf Hochspannungspotenzial (beispielsweise bei einem Potenzial bis zu 800 kV) zu messen. Es ist ausreichend, wenn die Faraday-Sensoreinrichtung sich in dem Magnetfeld um den Hochspan nungs-Stromleiter befindet. Besonders vorteilhaft ist es jedoch, wenn die Faraday-Sensoreinrichtung wie eben beschrieben eine Lichtfaser oder dergleichen umfasst, und die Lichtfaser um den Hochspannungs-Stromleiter gewickelt ist. Die besonderen Vorteile der Messvorrichtung im Zusammenhang mit Mittel- und Hochspannungsanlagen ergeben sich aus der Möglichkeit zur wirksamen Potenzialtrennung zwischen dem Hochspannungs-Stromleiter und der Messvorrichtung. Die Faraday-Sensoreinrichtung kann beispielsweise in der Nähe von sich auf Mittel- oder Hochspannungspotenzial befindenden Teile einer Mittel- oder Hochspannungsanlage angeordnet sein. Der Detektor sowie weitere Bauteile der Messvorrichtung können erdpotenzialnah angeordnet sein. Das Primär- und das Sekundärlichtsignal können über Lichtfasern zwischen der Faraday-Sensoreinrichtung und dem Detektor geführt sein. Aufgrund der möglichen räumlichen Trennung zwischen der Faraday-Sensoreinrichtung und dem Detektor und/oder dem Kompensationselement können der Aufbau und Installation der Messvorrichtung einfach und sicher gestaltet werden. Ist in der Hochspannungsanlage bereits ein Isolationselement, wie beispielsweise eine gasisolierte Schaltanlage (GIS) oder eine Hochspannungsdurchführung vorgesehen, so kann die Messvorrichtung aussen herum gewickelt werden. Die Lichtfasern der Messvorrichtung können durch einen Hohlraumisolator geführt werden. Bei Anwendungen im Bereich der Hochspannungsgleichstromübertragung (HGÜ) sind auch weitere Distanzen zwischen der Faraday-Sensoreinrichtung und den Detektor (bis zu mehreren Kilometern) unter Umständen möglich und wünschenswert.

Für einen Einsatz im Zusammenhang mit der Erfindung eignet sich insbesondere eine dem Fachmann bekannte sogenannte Spun High Birefringence Faser (Spun HiBi Faser). Diese eignet sich sowohl als Sensorfaser als auch für einen Transport der Polarisationsinformation.

Gemäß der Erfindung sind die Lichtquelle und der Detektor erdpotenzialnah angeordnet, wobei die Lichtquelle ein Lichterzeugungselement sowie ein davon beabstandetes Polarisati onselement umfasst, wobei das Lichterzeugungselement und das Polarisationslement mittels eines Lichtwellenleiters miteinander verbunden sind, und wobei die Messvorrichtung ferner eine polarisationserhaltende Lichtfaser zum Führen des Primärlichtsignals umfasst, die das Polarisationselement und die Faraday-Sensoreinrichtung miteinander verbindet. Demnach können vorteilhaft Teile der Messvorrichtung derart räumlich aufgetrennt werden, dass die Weglänge zwischen der sich in der Nähe des auf Hochspannungspotenzial angeordneten Hochspannungs-Stromleiters befindenden Faraday-Sensoreinrichtung und dem Polarisationselement möglichst kurz ist. Dies erlaubt eine vorteilhafte Kostensenkung der Messvorrichtung: Für den relativ kurzen Weg zwischen Polarisationselement und der Faraday-Sensoreinrichtung wird die relativ teure polarisationserhaltende Lichtfaser zur Führung des Primärlichtsignals verwendet; auf dem restlichen, relativ langen Weg von dem Lichterzeugungselement und dem Polarisationselement kann, da dort das Licht noch keine wohldefinierte Polarisation haben muss, der relativ kostengünstige Lichtwellenleiter verwendet werden. Auf diese Weise kann das Lichterzeugungselement räumlich variabel angeordnet werden, ohne die Kosten der Messvorrichtung entscheidend zu beeinflussen.

Ein weiterer Vorteil kann erreicht werden, wenn der Detektor einen Polarisationsanalysator sowie einen davon beabstandeten Intensitätssensor umfasst, wobei der Polarisationsanalysator und der Intensitätssensor mittels eines weiteren Lichtwellenleiters miteinander verbunden sind, und wobei die Messvorrichtung ferner eine weitere polarisationserhaltende Lichtfaser zum Führen des Sekundärlichtsignals umfasst, die die Faraday-Sensoreinrichtung und den Polarisationsanalysator miteinander verbindet. Die vom Polarisationsanalysator gelieferte Information über den Polarisationszustand des Sekundärlichtsignals ist in der Intensität des vom Polarisationsanalysator bereitgestellten Lichts enthalten. Somit muss dieses Licht keine definierte Polarisation aufweisen. Daher kann zur Führung des vom Polarisationsanalysator bereitgestellten Lichts der kostengünstige weitere Lichtwellenleiter verwendet werden.

Es ist denkbar, dass das Primär- bzw. Sekundärlichtsignal in Form von modulierten Signalen vorliegt. In diesem Fall kann Phasenmodulation und/oder Intensitätsmodulation verwendet werden.

Im Allgemeinen können zum Führen des Primärlichtsignals und des Sekundärlichtsignals zwei getrennte Lichtfasern vorgesehen sein. Es ist jedoch ebenfalls möglich, dass das Primär- und das Sekundärlichtsignal in einer gemeinsamen Lichtfaser geführt sind. Es kann ferner von Vorteil sein, wenn die wenigstens eine Lichtfaser an ihrem Ende mit Spiegeln und/oder mindestens einer Quaterwave-Platte zur weiteren Beeinflussung der Polarisation ausgestattet ist.

Bevorzugt ist der Detektor ortsnah an der kompensierenden Faraday-Sensoreinrichtung angeordnet. Dies erlaubt eine kompaktere Bauweise der Messvorrichtung. Beispielsweise können der Detektor und die kompensierende Faraday-Sensoreinrichtung in einem Isolatorfuß eines Isolators angeordnet sein, der sich zwischen dem Hochspannungs-Stromleiter und der Erde oder sich einem erdpotenzialnah befindenden Teil einer Hochspannungsanlage erstreckt.

Bevorzugt durchläuft das Sekundärlichtsignal eine kompensierende Faraday-Sensoreinrichtung, die ortsnah an einer Kompensations-Stromleitung angeordnet ist. Die Nullregelung wird dabei mit einem Kompensationsstrom durch die Kompensations-Stromleitung als Stellgröße durchgeführt.

Die Erfindung wird im Folgenden anhand der Figuren 1 bis 3 weiter erläutert.
Figur 1 zeigt einen schematischen Aufbau eines Ausführungsbeispiels einer Messvorrichtung gemäß der Erfindung;
Figur 2 zeigt ein weiteres Ausführungsbeispiel der erfindungsgemäßen Messvorrichtung in schematischer Darstellung;
Figur 3 zeigt ein weiteres alternatives Ausführungsbeispiel der erfindungsgemäßen Vorrichtung in schematischer Darstellung.

Dementsprechend ist in der Figur eine Skizze einer Messvorrichtung 1 dargestellt. Die Messvorrichtung 1 umfasst eine Faraday-Sensoreinrichtung 2, die in der Nähe eines Hochspannungs-Stromleiters 3 angeordnet ist. Die Faraday-Sensoreinrichtung 2 umfasst eine Mehrzahl von Lichtfaser-Wicklungen 21, die um den Hochspannungs-Stromleiter 3 gewickelt sind. In der hier dargestellten Variante ist der Stromleiter 3 Teil einer Hochspannungsanlage (nicht dargestellt). Der Hochspannungs-Stromleiter 3 befindet sich also auf Hochspannungspotenzial. Zu einer Potentialtrennung zwischen dem Hochspannungspotenzial und dem Erdpotenzial ist eine Isolationselement 4 vorgesehen, dass sich zwischen dem Hochspannungs-Stromleiter 3 und der Erde erstreckt und hier dargestellt als Hohlisolator ausgebildet ist. Das Isolationselement 4 umfasst ferner einen Isolatorfuß 41, auf dem das Isolationselement 4 aufgestellt ist.

Die Messvorrichtung 1 umfasst ferner eine Lichtquelle 5. Die Lichtquelle 5 weist eine Lichterzeugungselement 51 und ein Polarisationselement 52 auf. Das Polarisationselement 52 ist im Isolatorfuß 41 angeordnet. Das Lichterzeugungselement 51 ist in einem Gebäude 7 angeordnet. Das Gebäude 7 ist zur Aufnahme von Teilen der Messvorrichtung 1 sowie weiterer Teile der Hochspannungsanlage eingerichtet. Mittels einer Linie 18 ist in der Figur angedeutet, dass die Entfernung zwischen dem Gebäude 7 und dem Isolationselement 4 bis zu mehreren tausend Metern betragen kann. Das Lichterzeugungselement 51 und das Polarisationselement 52 sind miteinander mittels eines Lichtwellenleiters 53 verbunden.

Der Detektor umfasst einen Polarisationsanalysator 61, einen Intensitätssensor 62 sowie einen Lichtwellenleiter 63, wobei der Lichtwellenleiter 63 den Polarisationsanalysator 61 mit dem Intensitätssensor 62 verbindet. Der Polarisationsanalysa tor 61 ist in der dargestellten Form im Isolatorfuß 41 angeordnet. Der Intensitätssensor 62 ist im Gebäude 7, ebenfalls auf Erdpotenzial angeordnet.

Die Messvorrichtung 1 umfasst ferner eine kompensierende Faraday-Sensoreinrichtung 8, die in einer zwischen dem Polarisationsanalysator 61 und der Faraday-Sensoreinrichtung 2 sich erstreckenden Lichtfaser 19 integriert ist. In dem in der Figur dargestellten Ausführungsbeispiel der Erfindung ist die kompensierende Faraday-Sensoreinrichtung 8 als eine Faserspule ausgebildet, wobei die Faserwicklungen der Faserspule um einen Kompensationsstromleiter 9 gewickelt sind. Im dargestellten Ausführungsbeispiel umfasst der Kompensations-Stromleiter 9 mehrere Wicklungen eines Stromleiters.

Darüber hinaus umfasst die Messvorrichtung 1 eine Regelungseinrichtung 10, die in der hier dargestellten Variante in dem Gebäude 7 angeordnet ist. In der Figur ist die Regelungseinrichtung 10 vereinfacht dargestellt. Die Regelungseinrichtung 10 umfasst dementsprechend einen Messwiderstand 11, eine Rückkopplungsglied 12, sowie eine Spannungsquelle 13. Die Regelungseinrichtung 10 ist mittels elektrisch leitender Verbindungen 14 und 15 mit dem Kompensationsstromleiter 9 verbunden, so dass ein entsprechender Stromkreis gebildet ist.

Im dargestellten Ausführungsbeispiel bilden die kompensierende Faraday-Sensoreinrichtung 8, der Kompensations-Stromleiter 9 und die Regelungseinrichtung 10 Elemente eines Kompensationselementes aus.

Im Folgenden soll auf die Funktionsweise der Messvorrichtung 1 näher eingegangen werden. Mittels des Lichterzeugungselements 51 wird ein Lichtsignal erzeugt. Dieses Lichtsignal weist noch keine definierte Polarisation auf. Das Lichtsignal wird über den Lichtwellenleiter 53 dem Polarisationselement 52 zugeführt. Dem Lichtsignal wird mittels des Polarisationselements 52 ein wohldefinierter Polarisationszustand zugeordnet. Am Ausgang des Polarisationselements 52 wird demnach das polarisierte Primärlichtsignal bereitgestellt. Das Primärlichtsignal wird mittels einer polarisationserhaltenden Lichtfaser 16 zu der Faraday-Sensor-Einrichtung 2 geführt. Das Primärlichtsignal umläuft den Hochspannungsstromleiter 3. Im in der Figur dargestellten Ausführungsbeispiel der Messvorrichtung 1 ist das Primärlichtsignal linear polarisiert. Dies bedeutet, dass das Primärlichtsignal einen wohldefinierten Polarisationswinkel gegenüber einem vorgegebenen Nullwinkel, bspw. null Grad, aufweist. Aufgrund des Faradayeffekts im Magnetfeld des Hochspannungsstromleiters 3 verändert sich dieser Polarisationswinkel. Dies bedeutet, dass am Ausgang der Faraday-Sensor-Einrichtung ein polarisationsverändertes Sekundärlichtsignal bereitgestellt ist. Das Sekundärlichtsignal durchläuft die Lichtfaser 19 und wird in die kompensierende Faraday-Sensor-Einrichtung 8 geführt. Mittels des den Kompensationsstromleiter 9 durchflossenen Stromes kann hierbei ein Magnetfeld erzeugt werden, das eine entgegengesetzte Polarisationsänderung des Sekundärlichtsignals in der kompensierenden Faraday-Sensor-Einrichtung bewirkt.

Im Folgenden wird zu Erläuterungszwecken davon ausgegangen, dass bei einem gegebenen Strom ih durch den Hochspannungs-Stromleiter 3 das Sekundärlichtsignal eine Polarisationsänderung aufweist, die einer Drehung der Polarisationsebene um einen Winkel ah entspricht. Die entgegengesetzte Polarisierung in der kompensierenden Faraday-Sensoreinrichtung 8 bewirkt beispielsweise bei einem gegebenen Wert ik des Kompensationsstromes eine Drehung des Polarisationswinkels um den zusätzlichen Winkel ak, der auch negative Werte annehmen kann. Somit weist das Sekundärlichtsignal am Ausgang der kompensierenden Faraday-Sensoreinrichtung insgesamt eine Drehung der Polarisationsebene um den Winkel ah+ak auf. Abhängig von dem Winkel ah+ak wird im Polarisationsanalysator 61 ein Intensitätssignal erzeugt und an den Intensitätssensor 62 gegeben. Der Polarisationsanalysator 61 ist derart eingestellt, dass er für den Winkel ah+ak=0° ein Intensitätssignal null ausgibt. Ist das Intensitätssignal ungleich null, so wird über das Rückkopplungsglied 12 eine positive bzw. negative Verstärkung des Kompensationsstromes bewirkt. Ob eine Überkompensation oder eine Unterkompensation vorliegt, d. h. eine positive oder negative Verstärkung angewandt werden soll, kann beispielsweise mittels einer zusätzlichen geeigneten Messung, einer geeignet gewählten Auswertung oder über ein überlagertes hochfrequentes Signal außerhalb des Messbereiches ermittelt werden. Auf diese Weise wird wiederum der Wert des Winkels ak beeinflusst. Ist der Kompensationsstrom ik schließlich derart eingestellt, dass er eine Drehung der Polarisationsebene um einen Winkel ak mit ah+ak=0 bewirkt, so ist die vollständige Kompensation der Polarisationsänderung des Sekundärlichtsignals durch entgegengesetzte Polarisation erreicht. Die am Messwiderstand 11 gemessene Spannung Umax bei diesem Kompensationsstrom trägt die Information über den elektrischen Strom ih im Hochspannungs-Stromleiter 3.

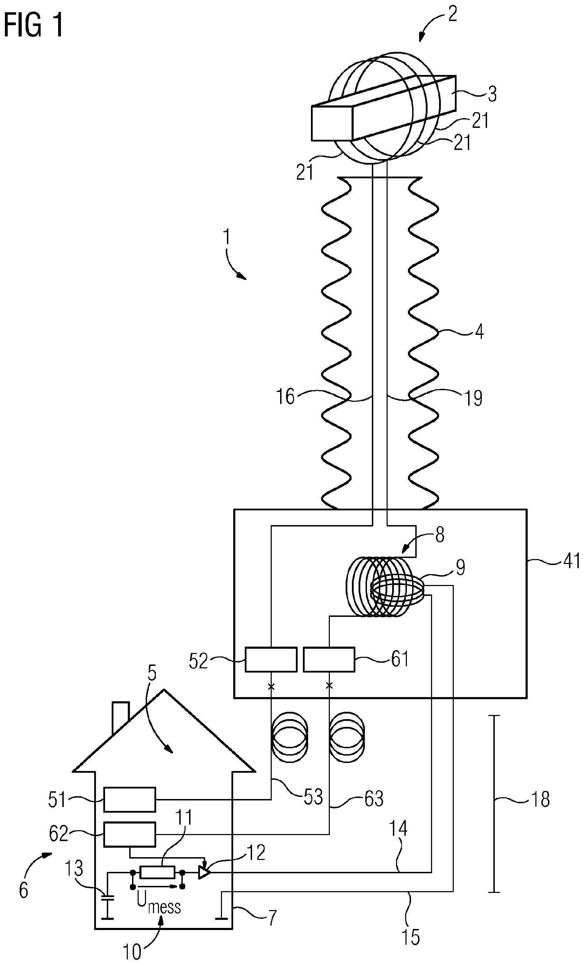

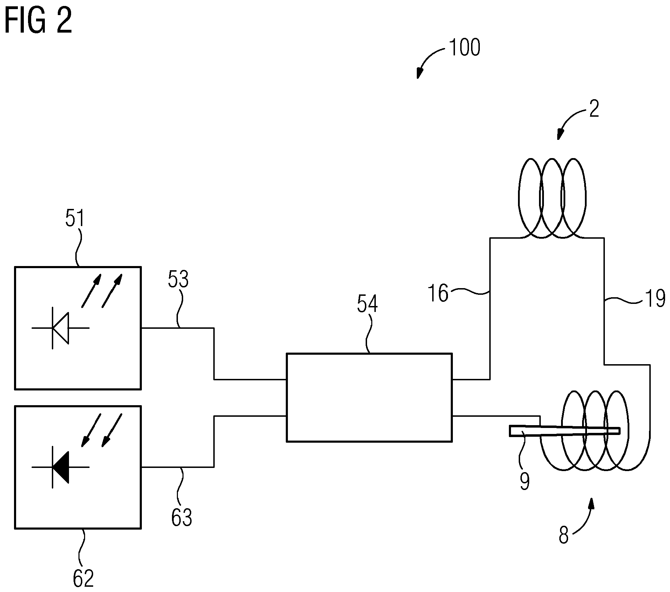

In Figur 2 ist ein weiteres Ausführungsbeispiel der erfindungsgemäßen Messvorrichtung 100 skizziert. In den Figuren 1 und 2 wurden gleiche Bauteile mit gleichen Bezugszeichen versehen. Die prinzipielle Funktionsweise der Messvorrichtung 100 entspricht derjenigen der Messvorrichtung 1. Aus Übersichtlichkeitsgründen wird im Folgenden nur auf die Unterschiede zwischen den Ausführungsbeispielen der Figuren 1 und 2 näher eingegangen.

Die Messvorrichtung 100 der Figur 2 unterscheidet sich von der Messvorrichtung 1 der Figur 1 dadurch, dass das Polarisationselement 52 und der Polarisationsanalysator 61 in der Figur 1 in Figur 2 durch einen Phasenmodulator 54 ersetzt sind. Der Phasenmodulator 54 weist zwei Eingänge und zwei Ausgänge auf. Die Phaseneingänge und -ausgänge des Phasenmodulators 54 sind derart angeordnet, dass das Primärlichtsignal und das Sekundärlichtsignal den Phasenmodulator 54 durchlaufen.

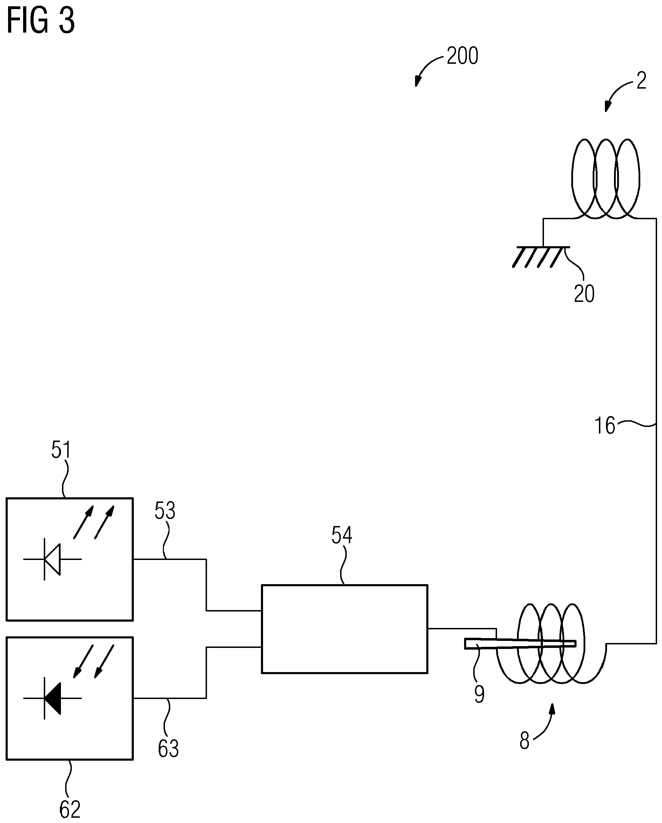

In Figur 3 ist ein alternatives Ausführungsbeispiel einer erfindungsgemäßen Messvorrichtung 200 skizziert. In den Figuren 1 und 3 wurden gleiche bzw. gleichartige Bauteile der Messvorrichtungen 100 bzw. 200 mit gleichen Bezugszeichen verseh en. Im Folgenden wird nur auf die Unterschiede zwischen den Messvorrichtungen 100 und 200 der Figuren 2 und 3 näher eingegangen.

Im Ausführungsbeispiel der Figur 3 weist die Messvorrichtung 200 ebenfalls einen Phasenmodulator 54. Der Phasenmodulator 54 der Messvorrichtung 200 weist zwei Eingänge und einen Ausgang auf. Damit fallen die polarisationserhaltenden Lichtfasern 16 und 19 der Messvorrichtung 100 der Figur 2 bei der Messvorrichtung 200 der Figur 3 zusammen. Somit durchläuft sowohl das Primärlichtsignal als auch das Sekundärlichtsignal die polarisationserhaltende Lichtfaser 16. Das Primärlichtsignal und das Sekundärlichtsignal sind in der Lichtfaser 16 überlagert. Die Messvorrichtung 200 umfasst ferner einen Spiegel 20, der an der Faraday-Sensoreinrichtung angeordnet ist. Am Spiegel 20 spiegelt sich das Primärlichtsignal und kehrt somit dessen Ausbreitungsrichtung um.

### Bezugszeichenliste

- 1,100,200: Messvorrichtung
- 2: Faraday-Sensoreinrichtung
- 21: Faserwicklung
- 3: Hochspannungs-Stromleiter
- 4: Isolationselement
- 41: Isolatorfuß
- 5: Lichtquelle
- 51: Lichterzeugungselement
- 52: Polarisationselement
- 53,63: Lichtwellenleiter
- 54: Phasenmodulator
- 6: Detektor
- 61: Polarisationsanalysator
- 62: Intensitätssensor
- 7: Gebäude
- 8: kompensierende Faraday-Sensoreinrichtung
- 9: Kompensations-Stromleiter
- 10: Regelungseinrichtung
- 11: Messwiderstand
- 12: Rückkopplungsglied
- 13: Spannungsquelle
- 14,15: Lichtwellenleiter
- 16, 19: polarisationserhaltende Lichtfaser
- 20: Spiegel

## Patentansprüche

1. Messvorrichtung (1) zum Messen eines elektrischen Stromes mit einer Lichtquelle (5) zum Erzeugen eines polarisierten Primärlichtsignals zum Einspeisen in eine Faraday-Sensoreinrichtung (2) sowie mit einem Detektor (6) zum Erfassen eines von der Faraday-Sensoreinrichtung (2) bereitgestellten, gegenüber dem Primärlichtsignal polarisationsveränderten Sekundärlichtsignals, wobei ein Kompensationselement (8, 9, 10), mittels dessen die Polarisationsänderung des Sekundärlichtsignals durch eine entgegengesetzte Polarisationsänderung kompensierbar und ein von der entgegengesetzten Polarisationsänderung abhängiges Meßsignal für den elektrischen Strom ableitbar ist, wobei die Faraday-Sensoreinrichtung (2) in der Nähe eines Hochspannungs-Stromleiters (3) einer Hochspannungsanlage angeordnet ist, so dass das Meßsignal für den elektrischen Strom in dem Hochspannungs-Stromleiter (3) ableitbar ist, wobei die Lichtquelle (5) und der Detektor (6) erdpotenzialnah angeordnet sind, wobei die Lichtquelle (5) ein Lichterzeugungselement (51) sowie ein davon beabstandetes Polarisationselement (52) umfasst,
**dadurch gekennzeichnet, dass**
das Lichterzeugungselement (51) und das Polarisationselement (52) mittels eines Lichtwellenleiters (53) miteinander verbunden sind, und wobei die Messvorrichtung (1) ferner eine polarisationserhaltende Lichtfaser (16) zum Führen des Primärlichtsignals umfasst, die das Polarisationselement (52) und die Faraday-Sensoreinrichtung (2) miteinander verbindet, wobei zu einer Potentialtrennung zwischen dem Hochspannungspotenzial und dem Erdpotenzial ein Isolationselement (4) vorgesehen ist, das sich zwischen dem Hochspannungs-Stromleiter (3) und der Erde erstreckt und einen Isolatorfuß (41) umfasst, auf dem das Isolationselement (4) aufgestellt ist, wobei das Polarisationselement (52) im Isolatorfuß (41) angeordnet ist, wobei das Lichterzeugungselement (51) in einem Gebäude (7) angeordnet ist, das zur Aufnahme von Teilen der Messvorrichtung (1) sowie weiterer Teile der Hochspannungsanlage eingerichtet eingerichtet ist.

2. Messvorrichtung (1) nach Anspruch 1, wobei das Kompensationselement (8, 9, 10) eine kompensierende Faraday-Sensoreinrichtung (8) sowie einen ortsnah an der kompensierenden Faraday-Sensoreinrichtung (8) angeordneten Kompensations-Stromleiter (9) umfasst, wobei das Sekundärlichtsignal die kompensierende Faraday-Sensoreinrichtung (8) durchläuft und ein Kompensationsstrom im Kompensations-Stromleiter (9) derart einstellbar ist, dass die Polarisationsänderung des Sekundärlichtsignals kompensierbar ist, wobei das Meßsignal in Abhängigkeit vom Kompensationsstrom ableitbar ist.

3. Messvorrichtung (1) nach Anspruch 2, wobei das Kompensationselement (8, 9, 10) eine Regelungseinrichtung (10) umfasst, die zu einer Nullregelung der Polarisationsänderung des Sekundärlichtsignals oder einer davon abgeleiteten Regelgröße mit Hilfe des Kompensationsstromes als Stellgröße eingerichtet ist.

4. Messvorrichtung (1) nach Anspruch 2 oder 3, wobei die Faraday-Sensoreinrichtung (2) und die kompensierende Faraday-Sensoreinrichtung (8) gleichartig aufgebaut sind.

5. Messvorrichtung (1) nach einem der vorangehenden Ansprüche, wobei der Detektor (6) zum Erfassen einer Lichtintensität in Abhängigkeit von einem Polarisationszustand des Sekundärlichtsignals eingerichtet ist.

6. Messvorrichtung (1) nach Anspruch 5, wobei der Detektor (6) einen Polarisationsanalysator (61) umfasst.

7. Messvorrichtung (1) nach Anspruch 6, wobei der Polarisationsanalysator (61) derart eingestellt ist, dass ein Sekundärlichtsignal ohne Polarisationsänderung ein Nullsignal an einem Ausgang des Detektors (6) ergibt.

8. Messvorrichtung (1) nach einem der vorangehenden Ansprüche, wobei die Faraday-Sensoreinrichtung (2) eine Lichtfaser-Spule oder einen Glasring zum Führen des Primärlichtsignals umfasst.

9. Messvorrichtung (1) nach Anspruch 1, wobei der Detektor (6) einen Polarisationsanalysator (61) sowie einen davon beabstandeten Intensitätssensor (62) umfasst, wobei der Polarisationsanalysator (61) und der Intensitätssensor (62) mittels eines weiteren Lichtwellenleiters (63) miteinander verbunden sind, und wobei die Messvorrichtung (1) ferner eine weitere polarisationserhaltende Lichtfaser (19) zum Führen des Sekundärlichtsignals umfasst, die die Faraday-Sensoreinrichtung (2) und den Polarisationsanalysator (61) miteinander verbindet.

10. Messvorrichtung (1) nach einem der vorangehenden Ansprüche, wobei der Detektor (6) ortsnah an der kompensierenden Faraday-Sensoreinrichtung (8) angeordnet ist.

## Claims

1. Measuring device (1) for measuring an electrical current, with a light source (5) for generating a polarized primary light signal for feeding into a Faraday sensor device (2), and with a detector (6) for detecting a secondary light signal provided by the Faraday sensor device (2) and altered in polarization in relation to the primary light signal, wherein a compensation element (8, 9, 10) is provided, by means of which the change in the polarization of the secondary light signal can be compensated for by an opposite change in the polarization, and a measurement signal that depends on the opposite change in the polarization can be derived for the electrical current, wherein the Faraday sensor device (2) is arranged close to a high-voltage electrical conductor (3) of a high-voltage installation, so that the measurement signal for the electrical current in the high-voltage electrical conductor (3) can be derived, wherein the light source (5) and the detector (6) are arranged close to earth potential, wherein the light source (5) comprises a light generation element (51) and, separate from it, a polarization element (52),
**characterized in that**
the light generation element (51) and the polarization element (52) are connected together by means of an optical waveguide (53), and wherein the measuring device (1) furthermore comprises a polarization-maintaining optical fibre (16) which serves to carry the primary light signal and connects the polarization element (52) and the Faraday sensor device (2) together, wherein an insulation element (4) is provided for an electrical isolation between the high-voltage potential and the earth potential and extends between the high-voltage electrical conductor (3) and the earth and comprises an insulator foot (41), on which the insulation element (4) is placed, wherein the polarization element (52) is arranged in the insulator foot (41), wherein the light generation element (51) is arranged in a building (7) set up to house parts of the measuring device (1) as well as further parts of the high-voltage installation.

2. Measuring device (1) according to Claim 1, wherein the compensation element (8, 9, 10) comprises a compensating Faraday sensor device (8) and a compensation electrical conductor (9) arranged close to the compensating Faraday sensor device (8), wherein the secondary light signal passes through the compensating Faraday sensor device (8), and a compensation current in the compensation electrical conductor (9) can be adjusted in such a way that the change in the polarization of the secondary light signal can be compensated, wherein the measurement signal can be derived from the compensation current.

3. Measuring device (1) according to Claim 2, wherein the compensation element (8, 9, 10) comprises a control device (10) that is designed for a zero-control of the change in the polarization of the secondary light signal or of a controlled variable derived from it, making use of the compensation current as the manipulated variable.

4. Measuring device (1) according to Claim 2 or 3, wherein the Faraday sensor device (2) and the compensating Faraday sensor device (8) have the same construction.

5. Measuring device (1) according any of the previous claims, wherein the detector (6) is designed to detect a light intensity depending on a polarization state of the secondary light signal.

6. Measuring device (1) according to Claim 5, wherein the detector (6) comprises a polarization analyser (61).

7. Measuring device (1) according to Claim 6, wherein the polarization analyser (61) is adjusted such that a secondary light signal without a change in the polarization results in a zero-signal at an output of the detector (6).

8. Measuring device (1) according to any of the previous claims, wherein the Faraday sensor device (2) comprises an optical fibre coil or a glass ring for guiding the primary light signal.

9. Measuring device (1) according to Claim 1, wherein the detector (6) comprises a polarization analyser (61) and, separate from it, an intensity sensor (62), wherein the polarization analyser (61) and the intensity sensor (62) are connected together by means of a further optical waveguide (63), and wherein the measuring device (1) furthermore comprises another polarization-maintaining optical fibre (19) which serves to carry the secondary light signal and connects the Faraday sensor device (2) and the polarization analyser (61) together.

10. Measuring device (1) according to any of the previous claims, wherein the detector (6) is arranged close to the compensating Faraday sensor device (8).

## Revendications

1. Système (1) de mesure d'un courant électrique comprenant une source (5) lumineuse de production d'un signal lumineux primaire polarisé pour l'injection dans un dispositif (2) capteur de Faraday ainsi qu'un détecteur (6) pour la détection d'un signal lumineux secondaire donné par le dispositif (2) capteur de Faraday et de polarisation modifiée par rapport au signal lumineux primaire, dans lequel il est prévu un élément (8, 9, 10) de compensation au moyen duquel la modification de polarisation du signal lumineux secondaire peut être compensée par une modification opposée de polarisation et un signal de mesure du courant électrique peut être déduit en fonction de la modification de polarisation opposée, dans lequel le dispositif (2) capteur de Faraday est disposé à proximité d'un conducteur (3) de courant de haute tension d'une installation de haute tension, de manière à pouvoir déduire le signal de mesure du courant électrique dans le conducteur (3) de courant de haute tension, dans lequel la source (5) lumineuse et le détecteur (6) sont disposés à proximité du potentiel de terre, dans lequel la source (5) lumineuse comprend un élément (51) de production de lumière ainsi qu'un élément (52) de polarisation, qui en est à distance,
**caractérisé en ce que**
l'élément (51) de production de lumière et l'élément (52) de polarisation sont reliés l'un à l'autre au moyen d'un guide (53) d'onde lumineuse et, dans lequel le système (1) de mesure comprend en outre une fibre (16) optique conservant la polarisation pour conduire le signal lumineux primaire, qui relie entre eux l'élément (52) de polarisation et le dispositif (2) capteur de Faraday, dans lequel pour une séparation de potentiel entre le potentiel de haute tension et le potentiel de terre, il est prévu un élément (4) isolant, qui s'étend entre le conducteur (3) de courant de haute tension et la terre et qui comprend un pied (41) d'isolateur, sur lequel est posé l'élément (4) isolant, dans lequel l'élément (52) de polarisation est disposé dans le pied (41) d'isolateur, dans lequel l'élément (51) de production de lumière est disposé dans un bâtiment (7), qui est agencé pour la réception de parties du système (1) de mesure ainsi que d'autres parties de l'installation de haute tension.

2. Système (1) de mesure suivant la revendication 1, dans lequel l'élément (8, 9, 10) de compensation comprend un dispositif (8) capteur de Faraday de compensation ainsi qu'un conducteur (9) de courant de compensation disposé près du dispositif (8) capteur de Faraday de compensation, le signal lumineux secondaire passant dans le dispositif (8) capteur de Faraday de compensation et un courant de compensation dans le conducteur (9) de courant de compensation pouvant être réglé de manière à pouvoir compenser la modification de polarisation du signal lumineux secondaire, le signal de mesure pouvant être déduit en fonction du courant de compensation.

3. Système (1) de mesure suivant la revendication 2, dans lequel l'élément (8, 9, 10) de compensation comprend un dispositif (10) de réglage, qui est agencé pour, à l'aide du courant de compensation comme grandeur de réglage, un réglage à zéro de la modification de polarisation du signal lumineux secondaire ou d'une grandeur de réglage, qui s'en déduit.

4. Système (1) de mesure suivant la revendication 2 ou 3, dans lequel le dispositif (2) capteur de Faraday et le dispositif (8) capteur de Faraday de compensation sont constitués de la même façon.

5. Système (1) de mesure suivant l'une des revendications précédentes, dans lequel le détecteur (6) est agencé pour la détection d'une intensité de la lumière en fonction d'un état de la polarisation du signal lumineux secondaire.

6. Système (1) de mesure suivant la revendication 5, dans lequel le détecteur (6) comprend un analyseur (61) de polarisation.

7. Système (1) de mesure suivant la revendication 6, dans lequel l'analyseur (61) de polarisation est réglé de manière à ce qu'un signal lumineux secondaire sans modification de la polarisation donne un signal nul à une sortie du détecteur (6).

8. Système (1) de mesure suivant l'une des revendications précédentes, dans lequel le dispositif (2) capteur de Faraday comprend une bobine à fibre optique ou un anneau en verre pour conduire le signal de lumière primaire.

9. Système (1) de mesure suivant la revendication 1, dans lequel le détecteur (6) comprend un analyseur (61) de polarisation ainsi qu'une capteur (62) d'intensité, qui en est à distance, dans lequel l'analyseur (61) de polarisation et le capteur (62) d'intensité sont reliés entre eux au moyen d'un autre guide (63) d'onde lumineuse et dans lequel le dispositif (1) de mesure comprend en outre une autre fibre (19) optique conservant la polarisation pour guider le signal de lumière secondaire, qui relie entre eux le dispositif (2) capteur de Faraday et l'analyseur (61) de polarisation.

10. Dispositif (1) de mesure suivant l'une des revendications précédentes, dans lequel le détecteur (6) est disposé près du dispositif (8) capteur de Faraday de compensation.
